# EUROPÄISCHE PATENTSCHRIFT

(11) **EP 0 812 060 B1**
(45) Veröffentlichungstag und Bekanntmachung des Hinweises auf die Patenterteilung: **15.03.2000**
(21) Anmeldenummer: 97109210.1
(22) Anmeldetag: 05.06.1997
(51) Int. Cl.: H03D 3/00, H03H 11/04

(54) **Filterschaltung mit Frequenzregelung**
Filter circuit with frequency adjustment
Circuit de filtrage avec réglage des fréquences

(30) Priorität: 05.06.1996 DE 19622656
(43) Veröffentlichungstag der Anmeldung: 10.12.1997
(73) Patentinhaber: SIEMENS AKTIENGESELLSCHAFT, 80333 München (DE)
(72) Erfinder: Fiesel, Hans, Dipl.-Ing. (FH), 79286 Glottertal (DE); Krug, Erwin, Dipl.-Ing., 81547 München (DE)

(56) Entgegenhaltungen:
- EP-A- 0 086 839
- EP-A- 0 437 970
- WO-A-81/00941
- US-A- 5 475 338
- PATENT ABSTRACTS OF JAPAN vol. 016, no. 441 (E-1264), 14.September 1992 & JP 04 154201 A (VICTOR CO OF JAPAN LTD), 27.Mai 1992,

## Beschreibung

Die Erfindung betrifft eine Filterschaltung mit Frequenzregelung nach dem Oberbegriff des Patentanspruchs 1.

Derartige eingangssignaladaptive Filterschaltungen werden auch als Tracking-Filter bezeichnet. Solche Filter finden in der Audio- und Videosignalverarbeitung Anwendung, um Oberwellen von Oszillatorsignalen zu dämpfen.

In der US-4 739 407 ist ein Tracking-Filter zum Empfang von NTSC-Signalen gezeigt. Das Eingangssignal wird über einen Eingangsverstärker einem steuerbaren Bandpaßfilter zugeführt. Ein Ausgangssignal des Bandpaßfilters wird in einem als Mischer dienenden Phasendetektor mit dem um 90° phasenverschobenen Eingangssignal verglichen. Das Ausgangssignal des Phasendetektors wird über einen Tiefpaß und einen Verstärker zur Steuerung des Bandpaßfilters rückgekoppelt. Das Bandpaßfilter enthält Varaktordioden und Induktivitäten. Eine Integration in einer integrierten Schaltung ist deshalb kaum möglich. Eine ähnliche Schaltung findet sich in EP-A-0 086 839.

In der WO 81/00941 ist ein anderes Tracking-Filter gezeigt, bei dem ein steuerbarer Bandpaß von einem Fehlersignal gesteuert wird. Dieses wird aus einem Phasendetektor gewonnen, der das Eingangssignal mit dem gefilterten Ausgangssignal vergleicht.

Die Aufgabe der Erfindung besteht darin, eine möglichst weitgehend integrierbare Filterschaltung mit Frequenzregelung anzugeben.

Erfindungsgemäß wird diese Aufgabe durch eine Filterschaltung gemäß den Merkmalen des Patentanspruchs 1 gelöst.

Die Filterschaltung kann mit verfügbaren Bauelementen mit geringem Aufwand realisiert werden. Es ist vorgesehen, das in seinem Durchlaßfrequenzbereich steuerbare Bandpaßfilter mit Spannungs-Strom-Wandlern, beispielsweise Transkonduktanzverstärkern oder Gyratoren zu realisieren. Hierzu erforderliche Kondensatoren haben eine ausreichend geringe Kapazität, so daß eine integrierte Realisierung ohne weiteres möglich ist. Allenfalls ein Kondensator zur Realisierung des Tiefpaßfilters muß als externes Bauelement bereitgestellt werden. Die Verwendung von Spannungs-Strom-Wandlern zur Realisierung von elektrisch steuerbaren Filtern ist in Hampel, Thomas; Palotas, Lazlo: "Entwurf elektrisch steuerbarer Filter mit Transkonduktanzverstärkern", Frequenz, Band 43, 1993, Heft 7 bis 8, Seiten 219 bis 223 beschrieben.

Das Tracking-Filter ist vorteilhafterweise bei der Audiomodulation anwendbar. Hierzu wird der Filterschaltung ein Audioträger zugeführt, der aufgrund seiner Erzeugung in einem Phasenregelkreis im wesentlichen ein Rechtecksignal ist. Durch die Filterschaltung werden die Oberwellen gedämpft, so daß im wesentlichen ein sinusförmiges Signal verbleibt, daß einem AM-Modulator zugeführt werden kann. Durch die Frequenzregeleigenschaft der Filterschaltung wird eine gleichbleibend gute Dämpfung der Oberwellen bei verschiedenen Frequenzen des Eingangsträgersignals für verschiedene Fernsehton-Standards erzeugbar.

Nachfolgend wird die Erfindung anhand des in der Zeichnung dargestellten Ausführungsbeispiels näher beschrieben. Die Figur zeigt eine erfindungsgemäße Filterschaltung mit einem Gyratorbandpaß.

Der Filterschaltung wird an einem Eingangsanschluß 1 ein Eingangssignal I zugeführt. Das Signal I wird in einen Bandpaß 3 eingespeist, an dessen Ausgang 2 ein gefiltertes Ausgangssignal O abgreifbar ist. Das Eingangssignal I ist beispielsweise ein Rechtecksignal, das folglich Frequenzanteile bei einer Grundschwingung aufweist sowie Oberwellen, also Frequenzanteile bei ganzzahligen Vielfachen der Grundschwingung.

Darüber hinaus ist denkbar, daß das Eingangssignal I bereits moduliert ist, beispielsweise FM moduliert. Der Betrag der Übertragungsfunktion des Bandbaßfilters weist bekanntlich bei seiner sogenannten Mittenfrequenz ein Maximum auf; die Dämpfung ist somit dort minimal. Der Phasenverlauf des Bandpaßfilters verändert sich mit steigender Frequenz von 0° auf 180°, wobei die Phasendrehung bei der Mittenfrequenz 90° beträgt. Für einen Bandpaß höherer Ordnung kann die Phasendrehung ein Mehrfaches von 90° betragen. Der Durchlaßfrequenzbereich des Bandpaßfilters 3 ist in Abhängigkeit von einem an einem Steuereingang 6 anliegenden Steuersignal verschiebbar. Dies bedeutet, daß die Mittenfrequenz des Bandpaßfilters verschiebbar ist. Das Ausgangssignal 0 des Bandpaßfilters ist bei der Mittenfrequenz in der Phase um 90° gegenüber dem Eingangssignal I verschccen, bei niedrigeren Frequenzen beträgt sie weniger als 90°, bei höheren Frequenzen mehr als 90°.

Das Ausgangssignal 0 sowie das ungefilterte Eingangssignal I werden einem Mischer 4 zugeführt. Das Ausgangssignal des Mischers 4 enthält Signalanteile bei Summen- und Differenzfrequenzen der Eingangssignale. Aufgrund der Phasenverschiebung von 90° der Eingangssignale des Mischers 4 werden unter anderem ein Gleichsignalanteil sowie Signalanteile bei Vielfachen der Grundfrequenz des Eingangssignals I erzeugt. Der Gleichanteil ist ein Maß für die Phasenabweichung der Eingangssignale des Mischers 4, also des gefilterten Ausgangssignals O und des ungefilterten Eingangssignals I. Der Ausgang des Mischers 4 ist über einen Tiefpaßfilter 5 mit dem Steuereingang 6 des Bandpaßfilters 3 verbunden. Das Tiefpaßfilter 5 ist nur für den Gleichsignalanteil des Mischerausgangssignals durchlässig. Durch das am Steuereingang 6 anliegende Steuersignal wird die Mittenfrequenz des Bandpaßfilters 3, bei der dessen Verstärkung maximal bzw. die Dämpfung minimal ist, nachgestellt. Diese Rückkoppelungsschleife wirkt gegenkoppelnd, so daß die Mittenfrequenz solange nachgestellt wird, bis der Gleichsignalanteil des Mischerausgangssignals, der die Regelabweichung darstellt, minimal wird. Dies ist dann der Fall, wenn die Grundfrequenz des Eingangssignals I mit der Mittenfrequenz des Bandpaßfilters 3 übereinstimmt. In diesem Fall wird der die Grundschwingung repräsentierende Signalanteil des Eingangssignals I durch das Bandpaßfilter um 90° gedreht und wird in der Amplitude maximal. Ist das Filter verstimmt, wenn z.B. beim Einschalten oder bei einem Frequenzwechsel die Mittenfrequenz von der Grundfrequenz des Eingangssignals abweicht, ist das Ausgangssignal des Mischers größer als im Fall von Abstimmung.

Der Mischer 4 wirkt als Phasendetektor, der feststellt, ob eine Phasenverschiebung von 90° zwischen den ihm zugeführten Eingangssignalen vorliegt. Wenn Bandpässe höherer Ordnung verwendet werden, bei denen eine Phasendrehung eines Vielfachen von 90° bei Mittenfrequenz erzeugt wird, ist ein solcher Phasendetektor zu verwenden, der das Vorliegen eben dieses Phasenunterschieds feststellt.

Das Bandpaßfilter 3 ist derart dimensioniert, daß Oberwellen des rechteckförmigen Eingangssignals I ausreichend gedämpft werden. Durch die beschriebene Frequenznachregelung wird das Bandpaßfilter stets auf den Grundfrequenzanteil des Eingangssignals I abgestimmt. Die Dämpfungswirkung des Bandpaßfilters 3 wirkt somit bezüglich der Oberwellensignalanteile unabhängig von der Grundfrequenz des Eingangssignals I und somit stets in bestmöglicher Weise.

Das Bandpaßfilter 3 ist zweckmäßigerweise, wie in der Figur gezeigt, mit Spannungs-Strom-Wandlern 7, 8 realisiert. Die Spannungs-Strom-Wandler sind als Transkonduktanzverstärker oder Gyratoren mit Differenzeingang ausgeführt. Durch die Wandler 7, 8 wird die an ihren Eingangsanschlüssen anliegende Differenzspannung in einen dazu proportionalen Ausgangsstrom gewandelt. Die Wandler 7, 8 sind ausgangsseitig über einen Kondensator 9 bzw. 10 mit Masse verbunden. Dem Minus-Eingang des Wandlers 7 wird das Eingangssignal I zugeführt, der Minus-Eingang des Wandlers 8 ist mit dem Ausgang des Wandlers 7 verbunden. Der Plus-Eingang des Wandlers 7 ist mit dem Ausgang des Wandler 8 verbunden, der Plus-Eingang des Wandlers 8 mit Masse. Die Steuereingänge der Wandler 7, 8, durch die deren Verstärkung einstellbar ist, werden von dem am Anschluß 6 anliegenden Steuersignal gesteuert. Darüber hinaus ist ein Verstärker 11 vorgesehen, der eingangsseitig mit dem Ausgang des Verstärkers 8 verbunden ist. Der Ausgang des Verstärkers 11 ist über einen Kondensator 12 mit dem Kondensator 9 und somit dem Ausgang des Wandlers 7 bzw. dem Minus-Eingang des Wandlers 8 verbunden. Der Ausgang des Verstärkers 11 bildet den Ausgang des Bandpaßfilters und ist außerdem mit dem Ausgang 2 der Filterschaltung verbunden, an dem das Ausgangssignal 0 anliegt.

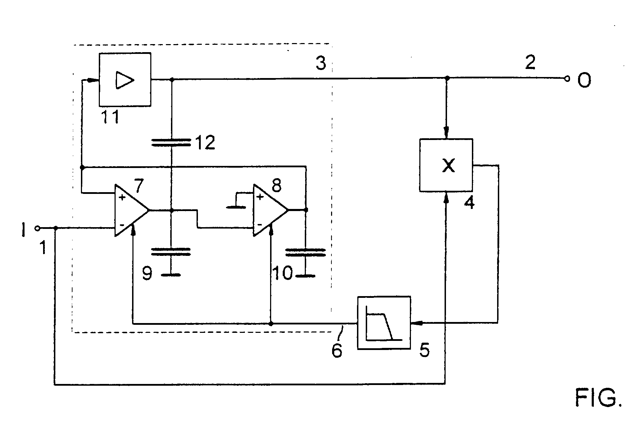

Vorteilhafterweise wird die in der Figur gezeigte Filterschaltung verwendet, um das rechteckförmige Ausgangssignal eines Phasenregelkreises, das einen Tonträger eines Fernsehsignals darstellt, derart zu filtern, daß die Oberwellen so weit unterdrückt werden, daß ausgangsseitig im wesentlichen ein sinusförmiges Signal vorliegt, welches zur Modulation in einem AM-Modulator verwendet werden kann. Das Eingangssignal I der Filterschaltung wird hierzu von einem spannungsgesteuerten Oszillator (VCO), der Teil eines Phasenregelkreises (Pll) ist, bereitgestellt. Gegebenenfalls ist das Signal mit einem gegenüber seiner Grundfrequenz niedrigfrequenten FM-modulierten Signalanteil überlagert. In Abhängigkeit von der Fernsehnorm weist das vom VCO bereitgestellte rechteckförmige Eingangssignal I 4,5; 5,5; 6 oder 6,5 MHz auf, die durch Einstellung entsprechender Teilerwerte im Phasenregelkreis erzeugt wird. Durch die in Figur 1 gezeigte frequenzgeregelte Bandpaßfilterschaltung wird der Oberwellensignalanteil des rechteckförmigen Eingangssignals I bei allen diesen verschiedenen Frequenzen gleich gut gedämpft, so daß das Ausgangssignal O jeweils nur im wesentlichen den Grundwellenanteil enthält und somit sinusförmig ist.

Die Kondensatoren 9, 10, 12 der Schaltung weisen bei den angegebenen Frequenzbereichen hinreichend kleine Kapazitätswerte auf und erfordern bei integrierter Realisierung einen vertretbar geringen Flächenbedarf. Allenfalls ein Kondensator zur Realisierung des Tiefpasses 5 muß bei einer ansonsten vollständig integrierten Realisierung außerhalb der integrierten Schaltung vorgesehen werden.

Der Mischer 4 kann als herkömmlicher analoger Multiplizierer aus kaskadierten Differenzverstärkerstufen realisiert werden, der die an seinen Eingängen anliegenden Spannungssignale miteinander multipliziert. Alternativ dazu ist auch eine Realisierung als digitaler Phasendetektor möglich, der die Phasenabweichung zwischen dem gefilteren Ausgangssignal O und dem ungefilterten Eingangssignal I in einen Stromimpuls umwandelt. Da das Ausgangssignal 0 sinusförmig ist, ist vor Einspeisung in den digitalen Phasenvergleicher eine Begrenzung mittels eines herkömmlichen Begrenzers erforderlich, so daß wiederum ein Rechtecksignal erzeugt wird, das der digitale Phasendetektor verarbeiten kann.

## Patentansprüche

1. Filterschaltung mit Frequenzregelung, enthaltend ein Bandpaßfilter (3), dem ein Eingangssignal (I) zuführbar ist, dessen Durchlaßfrequenzbereich steuerbar ist und an dem ausgangsseitig ein gefiltertes Ausgangssignal (O) der Filterschaltung abgreifbar ist, einen Phasendetektor (4), durch den das Eingangssignal (I) mit dem gefilterten Ausgangssignal (O) mischbar ist, und ein Tiefpaßfilter (5), über das ein am Phasendetektor (4) ausgangsseitig abgreifbares Signal dem Bandpaßfilter (3) zur Steuerung seines Durchlaßfrequenzbereiches zuführbar ist,
**dadurch gekennzeichnet**, daß
das Bandpaßfilter (3) mittels eines ersten Spannungs-Strom-Wandlers (7) realisiert ist mit einem Eingang (-), dem das Eingangssignal (I) zuführbar ist, und einem Ausgang, der über einen ersten Kondensator (9) nach Masse geschaltet ist, mittels eines zweiten Spannungs-Strom-Wandlers (8) mit einem Eingang (-), der mit dem Ausgang des ersten Spannungs-Strom-Wandlers (7) verbunden ist, und einem Ausgang, der über einen zweiten Kondensator (10) nach Masse geschaltet ist und auf einen weiteren Eingang (+) des ersten Spannungs-Strom-Wandlers (7) rückgekoppelt ist, und mittels eines Verstärkers (11) mit einem Eingang, der mit dem Ausgang des zweiten Spannungs-Strom-Wandlers (8) verbunden ist, und einem Ausgang, der über einen dritten Kondensator (12) mit dem Ausgang des ersten Spannungs-Strom-Wandlers (7) verbunden ist und an dem das gefilterte Ausgangssignal (O) abgreifbar ist.

2. Filterschaltung nach Anspruch 1,
**dadurch gekennzeichnet**, daß
diejenige Frequenz des Bandpaßfilters (3), bei der dessen Dämpfung minimal ist, steuerbar ist.

3. Filterschaltung nach Anspruch 1,
**dadurch gekennzeichnet**, daß
die ersten und zweiten Spannungs-Strom-Wandler (7, 8) Transkonduktanzverstärker oder Gyratoren sind.

4. Filterschaltung nach einem der Ansprüche 1 bis 3,
**dadurch gekennzeichnet**, daß
das Eingangssignal (I) ein im wesentlichen rechteckförmiges Signal ist.

5. Filterschaltung nach einem der Ansprüche 1 bis 4,
**dadurch gekennzeichnet**, daß
der Phasendetektor (4) als digitaler Phasendetektor ausgeführt ist, und daß das Ausgangssignal des Bandpaßfilters (3) dem digitalen Phasendetektor über einen Begrenzer zugeführt wird.

6. Filterschaltung nach einem der Ansprüche 1 bis 5,
**dadurch gekennzeichnet**, daß
der Phasendetektor (4) als analoger Multiplizerer ausgeführt ist.

## Claims

1. Filter circuit with frequency regulation, containing a bandpass filter (3), to which an input signal (I) can be fed, whose passband is controllable and on the output side of which a filtered output signal (0) of the filter circuit can be picked off, a phase detector (4), by which the input signal (I) can be mixed with the filtered output signal (O), and a low-pass filter (5), via which a signal that can be picked off on the output side of the phase detector (4) can be fed to the bandpass filter (3) for the purpose of controlling its passband,
characterized in that
the bandpass filter (3) is realized by means of a first voltage-current converter (7), having an input (-), to which the input signal (I) can be fed, and an output connected to earth via a first capacitor (9), by means of a second voltage-current converter (8) having an input (-), which is connected to the output of the first voltage-current converter (7), and an output which is connected to earth via a second capacitor (10) and is fed back to a further input (+) of the first voltage-current converter (7), and by means of an amplifier (11) having an input connected to the output of the second voltage-current converter (8), and having an output which is connected to the output of the first voltage-current converter (7) via a third capacitor (12) and at which the filtered output signal (O) can be picked off.

2. Filter circuit according to Claim 1,
characterized in that
that frequency of the bandpass filter (3) at which the attenuation of the said filter is a minimum is controllable.

3. Filter circuit according to Claim 1,
characterized in that
the first and second voltage-current converters (7, 8) are transconductance amplifiers or gyrators.

4. Filter circuit according to one of Claims 1 to 3,
characterized in that
the input signal (I) is an essentially square-wave signal.

5. Filter circuit according to one of Claims 1 to 4,
characterized in that
the phase detector (4) is designed as a digital phase detector, and in that the output signal of the bandpass filter (3) is fed to the digital phase detector via a limiter.

6. Filter circuit according to one of Claims 1 to 5,
characterized in that
the phase detector (4) is designed as an analogue multiplier.

## Revendications

1. Circuit de filtrage à régulation de fréquence, contenant un filtre (3) passe bande auquel peut être envoyé un signal (I) d'entrée, dont la plage de fréquence passante peut être commandée et sur lequel peut être prélevé côté sortie un signal (O) de sortie filtré du circuit de filtrage, un détecteur (4) de phase par lequel le signal (I) d'entrée peut être mélangé au signal (O) de sortie filtré, et un filtre (5) passe-bande par l'intermédiaire duquel un signal pouvant être prélevé côté sortie sur le détecteur (4) de phase peut être envoyé au filtre (3) passe-bande pour commander sa plage de fréquence passante, caractérisé en ce que le filtre (3) passe bande est réalisé au moyen d'un premier convertisseur (7) tension-courant ayant une entrée (-) auquel le signal (I) d'entrée peut être envoyé et une sortie qui est connectée à la masse par l'intermédiaire d'un premier condensateur (9), au moyen d'un deuxième convertisseur (8) tension-courant comportant une entrée (-) qui est reliée à la sortie du premier convertisseur (7) tension-courant et une sortie qui est connectée à la masse par l'intermédiaire d'un deuxième condensateur (10) et rétrocouplé à une entrée (+) supplémentaire du premier convertisseur (7) tension-courant, et au moyen d'un amplificateur (11) comportant une entrée qui est reliée à la sortie du deuxième convertisseur (8) tension-courant et une sortie qui est reliée par l'intermédiaire d'un troisième condensateur (12) à la sortie du premier convertisseur (7) tension-courant et à laquelle le signal (O) de sortie filtré peut être prélevé.

2. Circuit de filtrage suivant la revendication 1, caractérisé en ce que la fréquence du filtre (3) passe bande à laquelle son atténuation est minimum peut être commandée.

3. Circuit de filtrage suivant la revendication 1, caractérisé en ce que le premier et le deuxième convertisseur (7, 8) tension-courant sont des amplificateurs de transconductance ou des gyrateurs.

4. Circuit de filtrage suivant l'une des revendications 1 à 3, caractérisé en ce que le signal (I) d'entrée est un signal sensiblement rectangulaire.

5. Circuit de filtrage suivant l'une des revendications 1 à 4, caractérisé en ce que le détecteur (4) de phase est réalisé en détecteur de phase numérique et en ce que le signal de sortie du filtre (3) passe bande est envoyé au détecteur de phase numérique par l'intermédiaire d'un limiteur.

6. Circuit de filtrage suivant l'une des revendications 1 à 5, caractérisé en ce que le détecteur (4) de phase est réalisé en multiplicateur analogique.
